# EUROPÄISCHE PATENTSCHRIFT

(11) **EP 1 751 871 B1**
(45) Veröffentlichungstag und Bekanntmachung des Hinweises auf die Patenterteilung: **15.04.2015**
(21) Anmeldenummer: 05737814.3
(22) Anmeldetag: 20.04.2005
(51) Int. Cl.: H03M 1/12, H03M 7/50

(54) **VERFAHREN UND VORRICHTUNG ZUM AUTOMATISCHEN FESTLEGEN VON ZU CODEWORTEN GEHÖRENDEN WERTEBEREICHSGRENZEN FÜR ABTASTWERTE**
METHOD AND DEVICE FOR THE AUTOMATIC DEFINITION OF VALUE RANGE LIMITS THAT ARE ASSOCIATED WITH CODE WORDS FOR SAMPLING VALUES
PROCEDE ET DISPOSITIF POUR DETERMINER AUTOMATIQUEMENT DES LIMITES DE DOMAINES DE VALEURS APPARTENANT A DES MOTS CODES POUR DES VALEURS D'ECHANTILLONNAGE

(30) Priorität: 03.06.2004 DE 102004027146
(43) Veröffentlichungstag der Anmeldung: 14.02.2007
(73) Patentinhaber: Unify GmbH & Co. KG, 81379 München (DE)
(72) Erfinder: JANDEWERTH, Theodor, 45657 Recklinghausen (DE)
(74) Vertreter: Fritzsche, Thomas
(86) Internationale Anmeldenummer: PCT/EP2005/051756
(87) Internationale Veröffentlichungsnummer: WO 2005/119917

(56) Entgegenhaltungen:
- US-A1- 2004 015 349
- US-B1- 6 498 577
- NELSON M: "The data compression book, passage" DATA COMPRESSION BOOK, XX, XX, 1996, Seiten 17-20,75, XP002338207

## Beschreibung

Die Erfindung betrifft ein Verfahren, bei dem ein Gesamtwertebereich für Abtastwerte in Ursprungswertebereiche aufgeteilt wird. Jedem Ursprungswertebereich wird jeweils ein Codewort zugeordnet.

Die Abtastwerte werden beispielsweise bei der zeitlichen Abtastung eines kontinuierlichen Signals erzeugt, z.B. eines Sprachsignals oder eines Bildsignals. Beispielsweise wird bei der Abtastung eines Sprachsignals ein Abtastwert 0,7 Volt erzeugt.

Die Zuordnung von Ursprungswertebereichen zu Codeworten lässt sich mit Hilfe einer so genannten Quantisierungskennlinie graphisch verdeutlichen. Die Quantisierungskennlinie gibt den Zusammenhang von Abtastwerten und quantisierten Werten bzw. Codeworten graphisch wieder. Da mehrere Abtastwerte einem Ausgangswert bzw. eine Codewort zugeordnet sind, ist die Quantisierungskennlinie abgestuft. Beispielsweise sind Abtastwerte im Bereich von 0 Volt bis 0,2 Volt einem binären Codewort "0001" zugeordnet.

Es werden lineare Quantisierungskennlinien und nicht lineare Quantisierungskennlinien genutzt, wobei bei der Verwendung einer nicht linearen Quantisierungskennlinie im Vergleich zur Verwendung einer linearen Quantisierungskennlinie kleinere Quantisierungsfehler und damit kleinere Störungen entstehen. Der Schnittpunkt der Quantisierungskennlinie mit der x-Achse liegt auf einer waagerechten Linie oder auf einer vertikalen Sprunglinie der Quantisierungskennlinie.

Eine Quantisierung mit nicht linearer Quantisierungskennlinie lässt sich unter anderem durchführen:
- unter Verwendung einer nicht linearen Quantisierungskennlinie,
- unter Verwendung einer linearen Quantisierungskennlinie und einer vorhergehenden nicht linearen Transformation der Abtastwerte, oder
- durch eine lineare Quantisierung mit größerer Quantisierungslevelanzahl im Vergleich zu der Anzahl von verschiedenen Codeworten bei der nachfolgenden Übertragung unter Erzeugung von Zwischencodeworten, wobei anschließend aus den Zwischencodeworten die zu übertragenen Codeworte durch nicht lineare binäre Umrechnung ermittelt werden.

In dem US-Patent US 4,395,732 ist ein Analog-Digital-Wandler beschrieben, bei dem eine Serienschaltung von Kapazitäten zur Erzeugung von Referenzspannungen für die Komparatoren des Wandlers verwendet wird. Die digitale Datenausgabe des Wandlers wird zur Steuerung einer vorbestimmten zeitlich festgelegen Entladung einer ausgewählten Kapazität der Serienschaltung verwendet.

In dem US-Patent US 6,498,577 B1 ist ein ungleichförmiger Analog-Digital-Wandler beschrieben, bei dem die digitalen Ausgangsdaten die Größe eines analogen Eingangssignals repräsentieren, die eine ungleichförmige Größenwahrscheinlichkeitsverteilung aufweisen. Hierbei werden analoge Eingangssignale mit relativ höherer Auflösung dargestellt, deren Größe häufiger vorkommt, und analoge Eingangssignale mit relativ geringerer Auflösung für Eingangssignale dargestellt, deren Größe weniger häufig vorkommt.

Es ist Aufgabe der Erfindung ein einfaches Verfahren zum automatischen Festlegen von zu Codeworten gehörenden Wertebereichsgrenzen für Abtastwerte anzugeben, wobei das Verfahren insbesondere eine Quantisierung mit kleinem Quantisierungsfehler und kleiner Störung ermöglichen soll. Außerdem soll eine Vorrichtung angegeben werden, mit der sich insbesondere das erfindungsgemäße Verfahren durchführen lässt.

Die Erfindung wird definiert durch das Verfahren zur Abtastung eines kontinuierlichen Signals nach Anspruch 1 und durch die korrespondierende Vorrichtung nach Anspruch 9.

Die Erfindung geht von der Überlegung aus, dass bisher bei der Wahl der Quantisierungskennlinie die Verteilungsdichte der Abtastwerte im Fall einer linearen Quantisierungskennlinie nicht oder im Fall einer nicht linearen Quantisierungskennlinie nicht adaptiv berücksichtigt worden ist. Jedoch ist die Verteilungsdichte der Abtastwerte von der Zeit abhängig. Die statistische Verteilungsdichte lässt sich auch auf einfache Art ermitteln und für ein adaptives Verfahren nutzen.

Befinden sich beispielsweise die meisten Abtastwerte x(i) im Bereich von -2 < x < +2, wobei i den Abtastzeitpunkt angibt, so sollte dieser Wertebereich mit kleinen Quantisierungsschritten versehen werden. Die außerhalb dieses Bereiches liegenden Bereiche x < -2 und x > +2 sollten dagegen gröber quantisiert werden, d. h. in diesen Bereichen sollten die einem Codewort zugeordneten Wertebereiche Bereichsgrenzen haben, die auf einer linearen Zahlenskala weiter voneinander entfernt sind als die Bereichsgrenzen von Wertebereichen für ein Codewort innerhalb des Bereiches mit kleinen Quantisierungsschritten.

Deshalb werden bei dem erfindungsgemäßen Verfahren zusätzlich zu den eingangs genannten Verfahrensschritten die folgenden Verfahrensschritte durchgeführt:
- automatisches Ermitteln der Anzahl von Abtastwerten, die in einem Ursprungswertebereich liegen, für Abtastwerte eines Abtastintervalls, beispielsweise für alle Abtastwerte dieses Abtastintervalls oder für eine repräsentative Stichprobe dieses Abtastintervalls,
- automatisches Festlegen der Grenze eines geänderten Wertbereiches abhängig von der ermittelten Anzahl, und
- automatisches Zuordnen eines Codewortes zu dem geänderten Wertebereich.

Durch diese Vorgehensweise wird auf einfache Art und Weise eine Anpassung der Quantisierungsauflösung an die statistische Verteilung der Abtastwerte auf die Wertebereiche bzw. auf die Codeworte erzielt. Der Signal-Rausch-Abstand bei der Quantisierung mit der so erzeugten Quantisierungskennlinie ist klein. Die Quantisierungskennlinie wird beispielsweise periodisch aktualisiert, wobei die Periodendauer abhängig von dem Verlauf des abzutastenden Signals gewählt wird, insbesondere eine konstante Periodendauer oder eine Periodendauer, deren Wert adaptiv an das abzutastende Signal angepasst wird. Alternativ oder zusätzlich lässt sich die Quantisierungskennlinie auch abhängig vom Eintreten vorgegebener Ereignisse aktualisieren, beispielsweise beim Erfassen einer Sprachpause oder beim Erfassen eines Wechsels der Tonlage des zu übertragenden Signals.

Bei einer Weiterbildung wird abhängig von der ermittelten Anzahl von Abtastwerten für einen Ursprungswertebereich mindestens eine Wertebereichsgrenze eines geänderten Wertebereiches festgelegt, deren Wert innerhalb des Ursprungswertebereiches liegt. Mit anderen Worten gesprochen, wird eine waagerechte Linie der Ursprungs-Quantisierungskennlinie in zwei durch einen Sprung getrennte oder in mehrere durch jeweils einen Sprung voneinander getrennte waagerechte Linien aufgeteilt, um die Quantisierungsauflösung in einem Bereich zu erhöhen, in dem im berücksichtigten Abtastintervall sehr viele Abtastwerte aufgetreten sind.

Bei einer alternativen Weiterbildung wird abhängig von der ermittelten Anzahl von Abtastwerten der gesamte Ursprungswertebereich Teil eines geänderten Wertebereiches, der größer als der Ursprungswertebereich ist und der einem einzigen Codewort zugeordnet ist. Mit anderen Worten gesprochen, wird eine Wertebereichsgrenze eines Ursprungswertebereiches entfernt, ohne dass dafür eine Wertebereichsgrenze oder mehrere Wertebereichsgrenzen von geänderten Wertebereichen festgelegt werden. Die Quantisierungsauflösung in dem betreffenden Kennlinienabschnitt wird so verringert.

Bei einer nächsten Weiterbildung wird das Verfahren für alle Ursprungswertebereiche durchgeführt, so dass die gesamte Quantisierungskennlinie aktualisiert wird. Bei einer Ausgestaltung werden dabei alle Ursprungswertebereiche in der Reihenfolge bearbeitet, in der sie im Gesamtwertebereich angeordnet sind, beispielsweise mit aufsteigenden unteren Grenzwerten.

Bei einer nächsten Weiterbildung ist die Anzahl der Abtastwerte im Abtastintervall gleich der Anzahl der Ursprungswertebereiche oder gleich einem ganzzahligen Vielfachen der Anzahl der Ursprungswertebereiche. Im ersten Fall stimmt bei einem Einfügen von Sprüngen die Anzahl der einzufügenden Sprünge mit der Anzahl des Auftretens von Abtastwerten in dem betreffenden Ursprungswertebereich überein. Ein Sprung wird entfernt, wenn in einem Ursprungswertebereich keine Abtastwerte aufgetreten sind. Im zweiten Fall kann mit ganzzahligen Werten gerechnet werden.

Bei einer Weiterbildung wird ein Zwangsunterteilen oder ein Zwangszusammenfassen von geänderten Wertebereichen gemäß einer Korrekturvorschrift durchgeführt. Speziell für die Übertragung von Sprache ist oft eine ungleichmäßige Quantisierung erforderlich, um über einen großen Dynamikbereich das Signal-Rausch-Verhältnis konstant zu halten. Dazu wird z. B. bei der herkömmlichen Quantisierung die A-Kennlinie oder eine µ-Kennlinie verwendet. Durch diese Kennlinien wird erreicht, dass kleine Signalamplituden feiner und große Signalamplituden dafür gröber quantisiert werden. Eine diesen Kennlinien vergleichbare Funktion lässt sich verwenden, um zu gewährleisten, dass insbesondere bei kleinen Signalamplituden nicht zu große Quantisierungsschritte auftreten. Ebenso lässt sich aber verhindern, dass bei großen Signalamplituden keine Quantisierung mehr durchgeführt wird.

Die Erfindung betrifft außerdem eine Vorrichtung zum automatischen Festlegen von zu Codeworten gehörenden Wertebereichsgrenzen für Abtastwerte. Insbesondere ist die Vorrichtung zum Durchführen des erfindungsgemäßen Verfahrens oder einer seiner Weiterbildung geeignet, so dass die oben genannten technischen Wirkungen auch für die Vorrichtung gelten.

Die Vorrichtung enthält bei einer Weiterbildung einen Prozessor, der beim Ausführen eines Programms die Funktionen einer Ursprungszuordnungseinheit, einer Ermittlungseinheit und einer Festlegungseinheit erbringt. Bei einer alternativen Weiterbildung enthält die Vorrichtung eine Schaltungsanordnung, die keinen Prozessor enthält und die die Funktionen mindestens einer der genannten Einheiten oder aller dieser Einheiten erbringt. Bekannte Schaltungen für Analog/Digital-Wandler werden so modifiziert, dass Änderungen der zu Grunde liegenden Kennlinie berücksichtigt werden.

Das Aktualisieren der Quantisierungskennlinie wird bei einer Ausgestaltung sowohl auf einer Senderseite als auch auf einer Übertragungsseite durchgeführt, wobei die quantisierten Werte über eine Übertragungsstrecke übertragen werden, die zwischen dem Sender und dem Empfänger liegt. Bei einer solchen Vorgehensweise muss die geänderte Kennlinie nicht übertragen werden.

Bei einer alternativen Ausgestaltung wird die geänderte Kennlinie dagegen nur auf der Senderseite ermittelt. Die geänderte Kennlinie wird dann gemeinsam mit den zu übertragenden Daten an die Empfängereinheit gesendet. Durch diese Maßnahme muss auf der Empfängerseite keine Quantisierungskennlinie berechnet werden.

Im Folgenden werden Ausführungsbeispiele der Erfindung anhand der beiliegenden Zeichnungen erläutert.

Dabei zeigen:
- Figur 1:: Abtastwerte einer Abtastwertfolge, von der ein Teil der Abtastwerte zur Änderung einer Quantisierungskennlinie genutzt wird;
- Figur 2:: das Entfernen eines Quantisierungssprungs;
- Figur 3:: das Einfügen eines Quantisierungssprungs; und
- Figur 4:: eine ursprüngliche Quantisierungskennlinie und eine daraus erzeugte geänderte Quantisierungskennlinie.

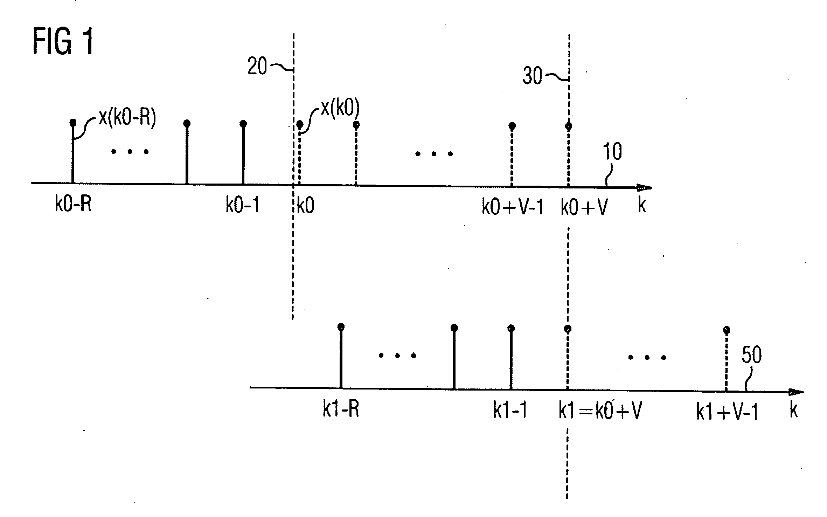

Figur 1 zeigt zugeordnet zu einer Abtastzeitskala 10 Abtastwerte x(k), die bei der Abtastung eines kontinuierlichen Signals mit einem konstanten Abtastintervall erzeugt worden sind, wobei k eine natürliche Zahl ist, die eine Position in der Abtastfolge angibt, in der die Abtastwerte x(k) in der Reihenfolge ihrer Erzeugung, d.h. mit zunehmenden Abtastzeiten angeordnet sind. Eine Position in der Abtastfolge kann damit genau einem Abtastzeitpunkt zugeordnet werden, in dem ausgehend von einer Position mit bekanntem Abtastzeitpunkt die Positionsdifferenz mit der Abtastintervalldauer multipliziert und von dem bekannten Abtastzeitpunkt abgezogen oder zu diesem Zeitpunkt addiert wird, je nachdem, ob die betreffende Position vor oder nach der Bezugsposition liegt.

Ein Bezugsabtastwert x(k0) gehört zu einer Position k0, bspw. zur Position 250. Beim Bearbeiten des Bezugsabtastwertes x(k0) wird auch das Aktualisieren einer Quantisierungskennlinie durchgeführt, siehe vertikale Linie 20. Zum Ermitteln der aktuellen Quantisierungskennlinie wird eine Fensterung über R Abtastwerte x(k0-R) bis x(k0-1) durchgeführt, die vor dem Bezugsabtastwert x(k0) liegen, wobei R eine natürliche Zahl ist. Bezeichnet k0 die Position 250, so liegen bei R = 12 die Abtastwerte x(238) bis x(249) innerhalb des Fensters.

Zur einfacheren Erläuterung haben in Figur 1 alle Abtastwerte x(k) die gleiche Größe, beispielsweise weil ein zeitlich konstantes Signal abgetastet wird. Üblicherweise sind die Abtastwerte x(k) jedoch voneinander verschieden, weil ein zeitlich veränderliches Signal vorliegt.

Im Ausführungsbeispiel stimmt die Fensterlänge R mit der Anzahl N der Zustände bzw. Codeworte überein, die durch zu übertragende Binärzahlen b(j) darstellbar sind, wobei j eine ganze Zahl zur Bezeichnung eines Zustands bzw. Codewortes ist. Beispielsweise hat ein Codewort b(1) den Wert 0001.

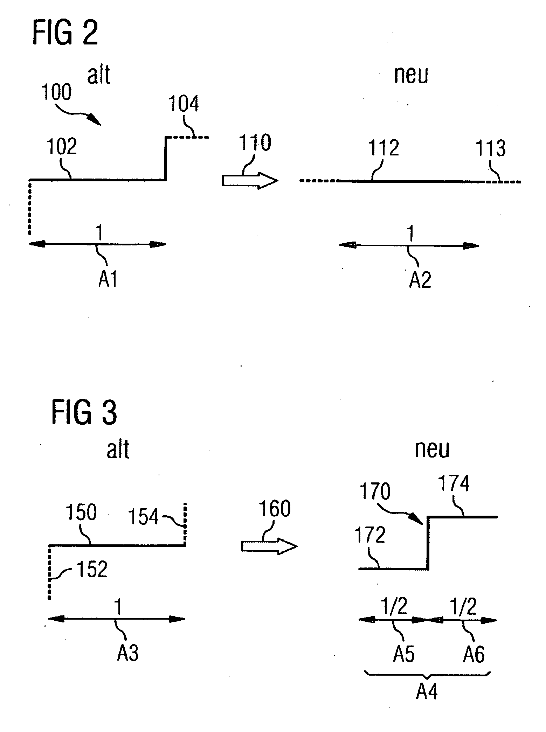

Die zur Änderung der Quantisierungskennlinie durchzuführenden Schritte werden unten an Hand der Figuren 2 bis 4 näher erläutert. Die geänderte Quantisierungskennlinie wird für die Übertragung der Abtastwerte x(k0) bis x(k0+V) genutzt, wobei V eine natürliche Zahl ist, insbesondere größer 100.

Nach der Übertragung von V Abtastwerten x(k) wird die Kennlinie erneut aktualisiert, siehe vertikale Linie 30. Beispielsweise werden die Kennlinien in Intervallen im Bereich von 50 Millisekunden bis 100 Millisekunden aktualisiert. Die Abtastrate beträgt bspw. 8000 pro Sekunde. Eine Abtastzeitskala 50 verdeutlicht die erneute Durchführung des Verfahrens bezogen auf einen Bezugsabtastwert x(k1), der mit dem Abtastwert x(k0+V) identisch ist.

Bei R = 12 werden beispielsweise die 12 vor dem Abtastwert x(k1) liegenden Abtastwerte x(k1-12) bis x(k1-1) zum erneuten Ändern der Quantisierungskennlinie verwendet. Mit der erneut geänderten Quantisierungskennlinie werden dann die Abtastwerte x(k1) bis k1+V-1 übertragen.

Bei jedem Ändern der Quantisierungskennlinien wird zunächst die Kennlinie verwendet, mit der die Abtastwerte x(kn-R) bis x(kn-1) quantisiert worden sind, wobei n eine natürliche Zahl zur Angabe der Bezugsposition ist. Beispielsweise von links nach rechts werden die waagerechten Anteile der Quantisierungskennlinie abschnittsweise näher untersucht, wobei jeder waagerechte Anteil einen Abschnitt bildet. Die mittleren Abschnitte sind jeweils durch zwei Sprünge begrenzt. In jedem Abschnitt werden so viele Sprünge eingebaut, wie quantisierte Werte b(j) übertragen worden sind. Dabei werden beispielsweise die anhand der Figuren 2 und 3 erläuterten Schritte ausgeführt.

Figur 2 zeigt das Entfernen eines Quantisierungssprungs 100 bezüglich eines Abschnitts A1 einer Ursprungs-Quantisierungskennlinie ohne entprechendes Einfügen eines Quantisierungssprungs in die geänderte Kennlinie. Der Quantisierungssprung 100 grenzt an eine horizontale Linie 102 des Abschnitts A1 und an eine horizontale Linie 104 des rechts neben dem Abschnitt A1 liegenden Abschnitts. Die Änderung der Quantisierungskennlinie wird durch einen Pfeil 110 angedeutet. Am rechten Rand eines Abschnitts A2 in der geänderten Quantisierungskennlinie gibt es keinen Sprung mehr. Eine waagerechte Linie 112 bildet gemeinsam mit einer waagerechten Linie 113 des rechts neben dem Abschnitt A2 liegenden Abschnitts oder Abschnittsteils eine waagerechte Linie. Die Abschnitte A1 und A2 haben die gleiche Länge, z. B. eine Länge 1, und sind dem gleichen Abtastwertebereich bezogen auf die Größe der Abtastwerte x(k) zugeordnet, z.B. dem gleichen Spannungsbereich. Ein Sprung wird dann entfernt, wenn in den Abtastwerten, die bei der Fensterung erfasst werden, kein Abtastwert enthalten ist, dessen Wert im Bereich A1 liegt.

Figur 3 zeigt das Einfügen eines Quantisierungssprungs bezüglich eines Kennlinienabschnitts A3 einer Ursprungs-Quantisierungskennlinie. Die Ursprungs-Quantisierungskennlinie hat im Abschnitt A3 einen konstanten Wert, so dass eine waagerechte Linie 150 entsteht, die von einem Sprung 152 am linken Ende des Abschnitts A3 und von einem Sprung 154 am rechten Ende des Abschnitts A3 begrenzt wird. Die Umwandlung der Quantisierungskennlinie wird durch einen Pfeil 160 angedeutet. Ein Abschnitt A4 mit der gleichen Länge wie der Abschnitt A3 und für den gleichen Abtastwertebereich wird in zwei Abschnitte A5 und A6 mit untereinander gleicher Länge aufgeteilt. An der Grenze zwischen dem Abschnitt A5 und dem Abschnitt A6 wird eine Sprung 170 eingefügt, der zwischen einer waagerechten Linie 172 und einer waagerechten Linie 174 liegt.

Der Sprung 170 bildet mit der links angrenzenden waagerechten Linie 172 eine Stufe, wobei die Linie 172 als Stufenfußlinie bezeichnet werden kann. Ebenso bildet der Sprung 170 mit der an ihm rechts angrenzenden waagerechten Linie 174 ein Stufe, wobei die Linie 174 dann als Stufendecklinie bezeichnet wird.

Mit anderen Worten gesprochen, wird eine waagerechte Linie durch ein Modul mit der gleichen Gesamtbreite ersetzt. Die Anzahl der im Abschnitt A3 übertragenen Werte während der Fensterung entspricht der Anzahl der einzufügenden Sprünge. Beträgt die Anzahl der übertragenen logischen Werte für b(j) beispielsweise 2, so wird ein Sprung im Abstand von 1/4 vom linken Rand des Abschnitts A4 und ein weiterer Sprung im Abstand von 1/4 vom rechten Rand des Abschnitts A4 eingefügt, falls die Länge des Abschnitts A3 gleich 1 war. Alternativ werden die Sprünge im Abstand von 1/3 vom linken Rand des Abschnitts A4 bzw. im Abstand von 1/3 vom rechten Rand des Abschnitts A4 angeordnet.

Falls die Anzahl der übertragenen logischen Werte für das Codewort B(j) beispielsweise 3 ist, so werden im Bereich der horizontalen Linie 150 drei Sprünge eingefügt, beispielsweise bei 1/6, 3/6 und 5/6 bezogen auf den linken Rand des Abschnitts A4. Entsprechend werden bei einer Anzahl n der zu übertragenden logischen Werte mit dem Codewort B(j) n-Sprünge an Stelle der waagerechten Linie 150 eingefügt, wobei sich die beiden äußeren Sprünge bspw. bei 1/n bzw. bei 1-1/n befinden und die übrigen n-2 Sprünge in gleichmäßigen Abständen zwischen den äußeren Sprüngen angeordnet werden.

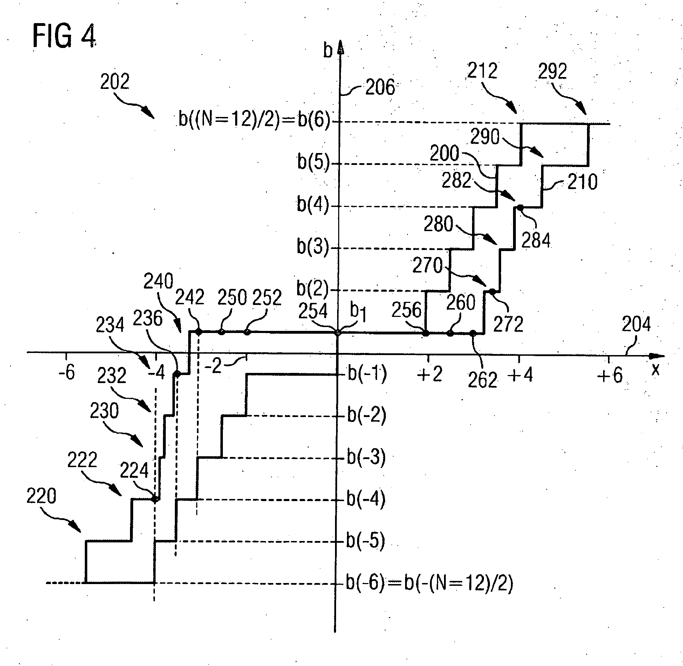

Figur 4 zeigt eine Ursprungs-Quantisierungskennlinie 200 in einem Koordinatensystem 202, das eine horizontale x-Achse 204 und eine vertikale y-Achse 206 hat. Auf der x-Achse 204 sind die Abtastwerte x im Bereich von -6 bis +6 abgetragen. Auf der y-Achse sind die Codeworte b abgetragen, insbesondere Codeworte b(-6) bis b(+6). Die Anzahl der Codeworte ist im Ausführungsbeispiel N gleich 12. Die Quantisierungskennlinie 200 und auch die daraus erzeugten Quantisierungskennlinien, insbesondere eine Quantisierungskennlinie 210, haben jeweils N, d.h. 12, Quantisierungslevel zwischen denen N-1 Sprünge liegen, siehe beispielsweise Sprung 212.

Die Quantisierungskennlinie 200 wurde verwendet, um die Abtastwerte x(k0-R) bis x(k0-1) zu den Zeitpunkten bzw. Abtastpositionen k0-R bis k0-1 zu übertragen. Die Kennlinie 200 hat den folgenden Verlauf:
- -6 < x ≤ -4 ergibt Codewort b(-6),
- -4 < x ≤ -3,5 ergibt Codewort b(-5),
- -3,5 < x ≤ 3 ergibt Codewort b(-4),
- -3 < x ≤ -2,5 ergibt Codewort b(-3),
- -2,5 < x ≤ -2 ergibt Codewort b(-2),
- -2 < x ≤ 0 ergibt Codewort b(-1),
- 0 < x ≤ +2 ergibt Codewort b(1),
- +2 < x ≤ +2,5 ergibt Codewort b(2),
- +2,5 < x ≤ +3 ergibt Codewort b(3),
- +3 < x ≤ +3,5 ergibt Codewort b(4),
- +3,5 < x ≤ +4 ergibt Codewort b(5),
- +4 < x ≤ +6 ergibt Codewort b(6).

Bei der Übertragung der Abtastwerte x(k0-R) bis x(k0-1) zu den Abtastzeitpunkten k0-R bis k0-1 sollen die folgenden Codeworte übermittelt worden sein:
- b(-5) wurde dreimal übermittelt,
- b(-6), b(6) und b(5) wurden jeweils zweimal übermittelt,
- b(-4) und b(4) wurden jeweils einmal übermittelt, und
- die Codeworte b(-3), b(-2), b(-1), b(1), b(2) und b(3) wurden nicht übertragen.

Da das Codewort b(-6) zweimal übertragen worden ist, erhält der Bereich -6 < x ≤ -4 zwei Sprünge 220, 222, wodurch die Quantisierungskennlinie 210 bis zu einem Punkt 224 festgelegt ist.

Das Codewort b(-5) wurde dreimal übertragen und besaß den Bereich -4 < x ≤ -3,5. Entsprechend erhält dieser Bereich drei Sprünge 230, 232 und 234, wodurch die Quantisierungskennlinie 210 bis zu einem Punkt 236 festgelegt ist.

Das Codewort b(-4) wurde einmal übertragen und besaß den Bereich -3,5 < x ≤ -3. Somit wird in diesem Bereich ein Sprung 240 eingefügt, wodurch die Quantisierungskennlinie 210 bis zu einem Punkt 242 festgelegt ist.

Die logischen Werte b(-3), b(-2), b(-1), b(1), b(2) und b(3) wurden nicht übertragen. In den dazugehörigen Bereichen -3 < x ≤ -2,5; -2,5 < x ≤ -2; -2 < x ≤ 0; 0 < x ≤ +2; +2 < x ≤ +2,5 und +2,5 < x ≤ +3 werden deshalb keine Sprünge eingefügt, siehe den Verlauf der Quantisierungskennlinie 210 vom Punkt 242 über Punkte 250, 252, 254, 256 und 260 bis zu einem Punkt 262.

Der logische Wert bzw. das Codewort b(4) wurde einmal übertragen. Der diesem Codewort b(4) zugehörige Bereich +3 < x ≤ +3,5 der Quantisierungskennlinie 200 erhält deshalb in der Quantisierungskennlinie 210 einen Sprung 270, so dass die Quantisierungskennlinie 210 bis zu einem Punkt 272 festgelegt ist.

Das Codewort b(5) wurde zweimal übertragen. Der dazugehörige Bereich +3,5 < x ≤ +4 erhält deshalb in der geänderten Quantisierungskennlinie 210 zwei Sprünge 280 und 282, wodurch die Quantisierungskennlinie 210 bis zu einem Punkt 284 festgelegt ist.

Der logische Wert b(6) wurde zweimal übertragen, so dass dem dazugehörigen Bereich +4 < x ≤ +6 zwei Sprünge 290 und 292 zugeordnet werden. Damit ist der gesamte Verlauf der Quantisierungskennlinie 210 festgelegt.

Die Sprünge 220, 222, 230, 234, 240, 270, 280, 282 und 290 sind gleich hoch, d.h. die Längen der vertikalen bzw. der parallel zur y-Achse 206 liegenden Sprunglinien dieser Sprünge sind untereinander gleich. Jedoch kommt es bei der Übertragung von Codeworten bzw. logischen Werten nicht auf den euklidischen Abstand zwischen Codeworten sondern nur auf deren Reihenfolge an, die für die Rücktransformation benötigt wird. Bei der Rücktransformation auf der Empfängerseite wird dem Codewort ein Wert aus dem Bereich zugeordnet, der dem Codewort auf der Senderseite zugeordnet ist, bspw. der Mittelwert dieses Bereiches, die untere Bereichsgrenze oder die obere Bereichsgrenze.

Bei einem anderen Ausführungsbeispiel werden dagegen an Stelle der logischen Werte bzw. Codeworte gerundete physikalische Werte übertragen. In diesem Fall wird die Lage der Sprünge und die Sprunghöhe an den Wertebereich auf der x-Achse angepasst. Insbesondere resultieren schmale Wertebereiche in einer kleinen Sprunghöhe und breite Wertebereiche in einer großen Sprunghöhe. Die Lage der waagerechten Linie stimmt bspw. mit dem Mittelwert des betreffenden x-Achsenbereiches überein. Diese Darstellungsform wird insbesondere bei reinen schaltungstechnischen Lösungen ohne Softwarekomponenten genutzt.

Für die Quantisierungskennlinie 210 gelten die folgenden Bereichsgrenzen:
- -6 < x ≤ -5,5 für das Codewort b(-6),
- -5,5 < x ≤ -4,5 für das Codewort b(-5),
- -4,5 < x ≤ -3,9167 für das Codewort b(-4),
- -3,9167 < x ≤ -3,75 für das Codewort b(-3),
- -3,75 < x ≤ -3,583 für das Codewort b(-2),
- -3,583 < x ≤ -3,25 für das Codewort b(-1),
- -3,25 < x ≤ +3,25 für das Codewort b(1),
- +3,25 < x ≤ +3,625 für das Codewort b(2),
- +3,625 < x ≤ +3,875 für das Codewort b(3),
- +3,875 < x ≤ +4,5 für das Codewort b(4),
- +4,5 < x ≤ +5,5 für das Codewort b(5), und
- +5,5 < x ≤ +6 für das Codewort b(6).

Damit ist aus der symmetrischen Quantisierungskennlinie 200 eine unsymmetrische Quantisierungskennlinie 210 entstanden. Symmetrische Quantisierungskennlinien sind ein Hinweis auf Abtastwerte mit dem Mittelwert Null.

Die anhand der Figur 4 erläuterte Umwandlung der Quantisierungskennlinie 200 in die Quantisierungskennlinie 210 wird bei einem Ausführungsbeispiel mit Hilfe eines Prozessors durchgeführt, der eine Befehlsfolge eines Programms ausführt. Für jedes Codewort werden nur die oben angegebenen Bereichsgrenzen gespeichert. Die Bereichsgrenzen lassen sich beispielsweise von einem Sender zu einem Empfänger übertragen, so dass im Empfänger das erläuterte Verfahren nicht durchgeführt werden muss. Alternativ werden die Verfahren zum Umwandeln der Kennlinie 200 in die Quantisierungskennlinie 210 jedoch sowohl in einem Sender als auch in einem Empfänger durchgeführt.

Bei einem weiteren Ausführungsbeispiel wird die geänderte Quantisierungskennlinie 210 nochmals korrigiert, indem beispielsweise in dem Bereich -3,25 < x ≤ +3,25 zwei Zwangssprünge eingefügt werden. In diesem Fall ist die Anzahl der Abtastwerte R im Fenster um den Wert zwei kleiner im Vergleich zu der Anzahl der Codeworte. Im Übrigen wird das Verfahren zum Umwandeln der Quantisierungskennlinie 200 auf gleiche Art und Weise durchgeführt.

Bei einem anderen Ausführungsbeispiel wird die Anzahl der übertragenen Abtastwerte für den jeweils betrachteten Abschnitt gewichtet. So ist für Bereiche mit betragsmäßig kleinen Amplitudenwerten die erfasste Anzahl zu vergrößern. Für Bereiche mit großen Amplitudenwerten ist die erfasste Anzahl entsprechend zu verkleinern. Hierzu bietet sich z. B. eine normierte A-Kennlinie an, wie sie von der Pulskodemodulation bekannt ist.

Mit Hilfe der erläuterten Verfahren kann die Quantisierungskennlinie 200, 210 an die zu übertragenden Abtastwerte partiell und dynamisch angepasst werden.

Bei anderen Ausführungsbeispielen ist die Anzahl der Quantisierungslevel größer oder kleiner als 12, z.B. 256.

Die Erfindung lässt sich generell bei allen Analog-Digital-Umwandlern sowie bei allen Digital-Analog-Umwandlern anwenden, bspw. im Gebiet der Mess- bzw. Regelungstechnik. Insbesondere wird die Erfindung sowohl bei einer Bearbeitung, z.B. Komprimierung, oder Übertragung von Sprachdaten, insbesondere von beim Telefonieren erzeugten Sprachdaten, als auch bei einer Übertragung von Bilddaten eingesetzt. Die Sprachdaten werden bspw. in durchschaltevermittelten Zeitschlitzkanälen oder in Datenpaketen übertragen, insbesondere in Datenpaketen gemäß Internetprotokoll (IP).

Die Grenzen 20 und 30 werden bspw. so gelegt, dass zu den zwischen diesen Linien liegenden Abtastwerten Codeworte erzeugt werden, die in demselben Datenpaket übertragen werden, wobei vorzugsweise nur diese Codeworte und keine anderen Codeworte in dem Datenpaket übertragen werden. Insbesondere wird die Kennlinienanpassung für jedes Datenpaket durchgeführt, das Codeworte enthält, die zu Abtastwerten der Abtastfolge gehören.

## Patentansprüche

1. Verfahren zur Abtastung eines kontinuierlichen Signals mit einem vorzugsweise konstanten Abtastintervall, wobei eine Ursprungs-Quantisierungskennlinie (200) adaptiv und abschnittsweise geändert wird und von zu Codeworten b(j), wobei j = 1, 2,..,N und N eine natürliche Zahl ist, gehörenden Wertebereichsgrenzen für Abtastwerte x(k), wobei k eine natürliche Zahl ist und eine Position in der Abtastfolge angibt, automatisch festgelegt werden, mit folgenden Verfahrensschritten,
a) gemäß der Ursprungs-Quantisierungskennlinie (200) werden jeweiligen Abtastwerten x(k) N Codeworte b(j) als Quantisierungslevel mit Wertebereichsgrenzen zugeordnet, wobei zwischen den N Quantisierungslevel N-1 Sprünge liegen,
b) bei dem ein Gesamtwertebereich für die Abtastwerte x(k) in N Ursprungswertebereiche (A1, A3) aufgeteilt wird,
c) bei dem den N Ursprungswertebereichen (A1, A3) jeweils ein Codewort b(j) zugeordnet wird,
d) bei dem für R Abtastwerte x(k0-R) bis x(k0-1) zu den Abtastzeitpunkten k0-R bis k0-1 in einem ersten Abtastintervall die Anzahl von Abtastwerten x(k) ermittelt wird, die in einem Ursprungswertebereich (A1, A3) liegen, wobei R eine natürliche Zahl ist,
e) bei dem abhängig von der ermittelten Anzahl von Abtastwerten x(k) eine Anpassung der Quantisierungsauflösung an die statistische Verteilung der Abtastwerte auf die Wertebereiche bzw. auf die Codeworte erzielt wird, indem mindestens ein Sprung (170) in einen Ursprungswertebereich (A1, A3) eingefügt wird oder ein Sprung an mindestens einer Ursprungswertebereichsgrenze entfernt wird, und
f) bei dem der geänderte Wertebereich (A2, A5) einem Codewort zugeordnet wird, wodurch eine geänderte Quantisierungskennlinie (210) für das nachfolgende zweite Abtastintervall mit V+1 Abtastwerten x(k0) bis x(k0+V) zu den Abtastzeitpunkten k0 bis k0+V erzeugt wird, wobei V eine natürliche Zahl ist und k0+V eine Position (30) bezeichnet.

2. Verfahren nach Patentanspruch 1,
**dadurch gekennzeichnet,**
**dass** nach dem Schritt f) folgender Schritt eingefügt wird:
g) nach der Übertragung von V Abtastwerten x(k) wird die geänderte Quantisierungskennlinie (210) erneut aktualisiert, wobei ausgehend von einem neuem Bezugsabtastwert x(k1), der mit dem Abtastwert x(k0+V) identisch ist, die Schritte d) bis f) durchgeführt werden, wobei der Abtastzeitpunkt k0 durch den neuen Abtastzeitpunkt k1 ersetzt wird.

3. Verfahren nach einem der vorhergehenden Patentansprüche,
**dadurch gekennzeichnet,**
**dass** in Schritt e) die Anzahl der Wertebereichsgrenzen (170), deren Wert innerhalb des Ursprungswertebereiches (A3) liegt, proportional zur Anzahl der Abtastwerte x(k) ist, insbesondere gleich der Anzahl von Abtastwerten x(k), die für den Ursprungswertebereich (A3) ermittelt worden sind (Fig. 3).

4. Verfahren nach einem der vorhergehenden Patentansprüche,
**dadurch gekennzeichnet,**
**dass** abhängig von der ermittelten Anzahl von Abtastwerten x(k) der gesamte Ursprungswertebereich (A1) Teil eines geänderten Wertebereiches (A2) wird, der größer als der Ursprungswertebereich (A1) ist und der einem einzigen Codewort zugeordnet ist (Fig. 2).

5. Verfahren nach Patentanspruch 4,
**dadurch gekennzeichnet,**
**dass** die ermittelte Anzahl von Abtastwerten x(k) den Wert Null hat (Fig. 2).

6. Verfahren nach einem der vorhergehenden Patentansprüche,
**dadurch gekennzeichnet,**
**dass** Schritt e) für alle Ursprungswertebereiche (A1, A3) durchgeführt wird, insbesondere in der Reihenfolge, in der die Ursprungswertebereiche (A1, A3) im Gesamtwertebereich angeordnet sind.

7. Verfahren nach einem der vorhergehenden Patentansprüche,
**dadurch gekennzeichnet,**
**dass** in Schritt d) die R Abtastwerte x(k-R) bis x(k0-1) im ersten Abtastintervall gleich der Anzahl N der Ursprungswertebereiche oder gleich einem ganzzahligen Vielfachen der Anzahl N der Ursprungswertebereiche ist.

8. Verfahren nach einem der vorhergehenden Patentansprüche,
**dadurch gekennzeichnet,**
**dass** eine Zwangsunterteilung oder ein Zwangszusammenfassen von geänderten Wertebereichen (A2, A5, A6) gemäß einer Korrekturvorschrift durchgeführt wird.

9. Vorrichtung zur Abtastung eines kontinuierlichen Signals mit einem vorzugsweise konstanten Abtastintervall, wobei eine Ursprungs-Quantisierungskennlinie (200) adaptiv und abschnittsweise geändert wird und von zu Codeworten b(j), wobei j = 1, 2, ..., N und N eine natürliche Zahl ist, gehörende Wertebereichsgrenzen für Abtastwerte x(k), wobei k eine natürliche Zahl ist und eine Position in der Abtastfolge angibt, automatisch festgelegt werden, mit folgenden Einheiten,
a) mit einer Ursprungszuordnungseinheit, die so ausgebildet ist, dass gemäß der Ursprungs-Quantisierungskennlinie (200) jeweiligen Abtastwerten x(k) N Codeworte b(j) als Quantisierungslevel mit Wertebereichsgrenzen zugeordnet werden, wobei zwischen den N Quantisierungslevel N-1 Sprünge liegen, wobei
b) ein Gesamtwertebereich für die Abtastwerte x(k) in N Ursprungswertebereiche (A1, A3) aufgeteilt wird, und
c) den N Ursprungswertebereichen (A1, A3) jeweils ein Codewort b(j) zugeordnet wird,
d) mit einer Ermittlungseinheit, die so ausgebildet ist, dass für R Abtastwerte x(k0-R) bis x(k0-1) zu den Abtastzeitpunkten k0-R bis k0-1 in einem ersten Abtastintervall die Anzahl von Abtastwerten x(k) ermittelt wird, die in einem Ursprungswertebereich (A1, A3), liegen, wobei R eine natürliche Zahl ist,
e) mit einer Festlegungseinheit, die so ausgebildet ist, dass abhängig von der ermittelten Anzahl von Abtastwerten x(k) eine Anpassung der Quantisierungsauflösung an die statistische Verteilung der Abtastwerte auf die Wertebereiche bzw. auf die Codeworte erzielt wird, indem mindestens ein Sprung (170) in einen Ursprungswertebereich (A1, A3) eingefügt wird oder ein Sprung an mindestens einer Ursprungswertebereichsgrenze entfernt wird, und
f) wobei der geänderte Wertebereich (A2, A5) einem Codewort zugeordnet wird, wodurch eine geänderte Quantisierungskennlinie (210) für das nachfolgende zweite Abtastintervall mit V+1 Abtastwerten x(k0) bis x(k0+V) zu den Abtastzeitpunkten k0 bis k0+V erzeugt wird, wobei V eine natürliche Zahl ist und k0+V eine Position (30) bezeichnet.

10. Vorrichtung nach Patentanspruch 9,
**dadurch gekennzeichnet,**
**dass** die Vorrichtung einen Prozessor enthält, der beim Ausführen eines Programms die Funktion der Ursprungszuordnungseinheit, der Ermittlungseinheit und der Festlegungseinheit erbringt, oder
**dass** die Vorrichtung eine Schaltungsanordnung enthält, die keinen Prozessor enthält und die die Funktion mindestens einer der genannten Einheiten oder aller dieser Einheiten erbringt.

## Claims

1. Method for sampling a continuous signal with a preferably constant sampling interval, wherein an original quantization characteristic (200) is changed adaptively and section by section, and by value range limits for sampling values x (k), where k is a natural number, which are associated with code words b (j), where j = 1, 2, ..., N and N is a natural number and indicates a position in the sampling sequence, are automatically defined, having the following process steps,
a) according to the original quantization characteristic (200), the respective sampling values x (k) are associated with N code words b (j) as quantization levels with value range limits, wherein N-1 jumps are located between the N quantization levels,
b) in which a total range of values for the sampling values x (k) is subdivided into N original value ranges (A1, A3),
c) in which, each time, a code word b (j) is associated with the N original value ranges (A1, A3),
d) in which, for R sampling values x (k0-R) to x (k0-1), at sampling times k0-R to k0-1 in a first sampling interval, the number of sampling values x (k) in an original value range (A1, A3) is determined, where R is a natural number,
e) in which, depending on the determined number of sampling values x (k), an adaptation of the quantization resolution to the statistical distribution of the sampling values in the value ranges or in the code words is achieved, by inserting at least one jump (170) in an original value range (A1, A3) or by removing one jump at at least one original value range limit, and
f) in which the changed value range (A2, A5) is associated with a code word, as a result of which a changed quantization characteristic (210) is generated for the subsequent second sampling interval with V+1 sampling values x (k0) to x (k0+V) at sampling times k0 to k0+V, where V is a natural number and k0+V designates a position (30).

2. Method according to Claim 1,
**characterized in**
**that**, after step f), the following step is inserted:
g) after the transfer of V sampling values x (k), the changed quantization characteristic (210) is updated again, wherein, starting from a new reference sampling value x (k1), which is identical to the sampling value x (k0+V), steps d) to f) are carried out, wherein the sampling time k0 is replaced by the new sampling time k1.

3. Method according to any one of the preceding claims,
**characterized in**
**that**, in step e), the number of value range limits (170), the value of which is within the original value range (A3), is proportional to the number of sampling values x (k), in particular equal to the number of sampling values x (k), which are determined for the original value range (A3) (Figure 3).

4. Method according to any one of the preceding claims,
**characterized in**
**that**, depending on the number of sampling values x (k) determined, the entire original value range (A1) becomes part of a changed value range (A2) which is greater than the original value range (A1) and which is associated with a single code word (Figure 2).

5. Method according to Claim 4,
**characterized in**
**that** the determined number of sampling values x (k) has the value zero (Figure 2).

6. Method according to any one of the preceding claims,
**characterized in**
**that** step e) is carried out for all the original value ranges (A1, A3), in particular in the sequence in which the original value ranges (A1, A3) are arranged in the total range of values.

7. Method according to any one of the preceding claims,
**characterized in**
**that**, in step d), the R sampling values x (k-R) to x (k0-1) in the first sampling interval is equal to the number N of original value ranges or equal to an integer multiple of the number N of the original value ranges.

8. Method according to any one of the preceding claims,
**characterized in**
**that** a compulsory subdivision or a compulsory combination of changed value ranges (A2, A5, A6) is carried out according to a correction procedure.

9. Device for sampling a continuous signal with a preferably constant sampling interval, wherein an original quantization characteristic (200) is changed adaptively and section by section, and by value range limits for sampling values x (k), where k is a natural number, which are associated with code words b (j), where j = 1, 2, ..., N and N is a natural number and indicates a position in the sampling sequence, are automatically defined, having the following units,
a) having an original association unit, which is formed so that, in accordance with the original quantization characteristic (200), respective sampling values x (k) are associated with N code words b (j) as quantization levels with value range limits, wherein N-1 jumps are located between the N quantization levels, wherein
b) a total range of values for the sampling values x (k) is subdivided into N original value ranges (A1, A3), and
c) in which, each time, a code word b (j) is associated with the N original value ranges (A1, A3),
d) having a determination unit which is formed so that, for R sampling values x (k0-R) to x (k0-1), at sampling times k0-R to k0-1 in a first sampling interval, the number of sampling values x (k) in an original value range (A1, A3) is determined, where R is a natural number,
e) having a definition unit, which is formed so that, depending on the determined number of sampling values x (k), an adaptation of the quantization resolution of the statistical distribution of the sampling values in the value ranges or in the code words is achieved, by inserting at least one jump (170) in an original value range (A1, A3), or by removing one jump at at least one original value range limit, and
f) wherein the changed value range (A2, A5) is associated with a code word, as a result of which a changed quantization characteristic (210) is generated for the subsequent second sampling interval with V+1 sampling values x (k0) to x (k0+V) at sampling times k0 to k0+V, where V is a natural number and k0+V designates a position (30).

10. Device according to Claim 9,
**characterized in**
**that** the device contains a processor which, at the time of the execution of a program, performs the function of the original association unit, of the determination unit and of the definition unit, or
in that the device contains a circuit arrangement which contains no processor and which performs the function of at least one of the mentioned units or of all these units.

## Revendications

1. Méthode pour échantillonner un signal continu avec un intervalle d'échantillonnage constant de préférence, dans laquelle une caractéristique de quantification d'origine (200) est modifiée de manière adaptative et section par section, et par limites de plages de valeurs pour des valeurs d'échantillonnage x (k), où k est un nombre naturel, associées avec des mots de code b (j), où j = 1, 2, ..., N, et N est un nombre naturel indiquant une position dans la séquence d'échantillonnage, et automatiquement définies, ayant les étapes de procédé suivantes :
a) en fonction de la caractéristique de quantification d'origine (200), les valeurs d'échantillonnage x (k) respectives sont associées à N mots de code b (j) lorsque la quantification et les limites de plages de valeurs s'égalisent, dans laquelle des sauts N-1 ont lieu entre les niveaux de quantification N,
b) où une plage totale de valeurs pour les valeurs d'échantillonnage x (k) est subdivisée en N plages de valeurs d'origine (A1, A3),
c) où, à chaque fois, un mot de code b (j) est associé aux N plages de valeurs d'origine (A1, A3),
d) où, pour R valeurs d'échantillonnage de x (k0-R) à x (k0-1), aux instants d'échantillonnage de k0-R à k0-1 dans un premier intervalle d'échantillonnage, le nombre de valeurs d'échantillonnage x (k) dans une plage de valeurs d'origine (A1, A3) est déterminé, où R est un nombre naturel,
e) où, en fonction du nombre de valeurs d'échantillonnage x (k) déterminé, une adaptation de la résolution de quantification de la distribution statistique des valeurs d'échantillonnage est réalisée dans les plages de valeurs ou dans les mots de code, en insérant au moins un saut (170) dans une plage de valeurs d'origine (A1, A3) ou en supprimant un saut dans au moins une limite de plage de valeurs d'origine, et
f) où la plage de valeurs modifiées (A2, A5) est associée à un mot de code, ce qui a pour conséquence de générer une caractéristique de quantification modifiée (210) pour le deuxième intervalle d'échantillonnage suivant avec V+1 valeurs d'échantillonnage x (k0) à x (k0+V) aux instants d'échantillonnage k0 à k0+V, où V est un nombre naturel et k0+V désigne une position (30).

2. Méthode selon la revendication 1,
**caractérisée en ce**
**que**, après l'étape f), l'étape suivante est insérée :
g) après le transfert de V valeurs d'échantillonnage x (k), la caractéristique de quantification modifiée (210) est à nouveau mise à jour, dans laquelle, en partant d'une nouvelle valeur d'échantillonnage de référence x (k1), identique à la valeur d'échantillonnage x (k0+V), les étapes d) à f) sont exécutées, dans laquelle l'instant d'échantillonnage k0 est remplacé par le nouvel instant d'échantillonnage k1.

3. Méthode selon l'une quelconque des revendications précédentes,
**caractérisée en ce**
**que**, à l'étape e), le nombre de limites de plages de valeurs (170), dont la valeur se situe dans la plage de valeurs d'origine (A3), est proportionnel au nombre de valeurs d'échantillonnage x (k), en particulier égal au nombre de valeurs d'échantillonnage x (k), qui sont déterminées par la plage de valeurs d'origine (A3) (Figure 3).

4. Méthode selon l'une quelconque des revendications précédentes,
**caractérisée en ce**
**que**, en fonction du nombre de valeurs d'échantillonnage x (k) déterminé, la plage de valeurs d'origine (A1) devient une partie d'une plage de valeurs modifiée (A2) supérieure à la plage de valeurs d'origine (A1) et qui est associée à un mot de code unique (Figure 2).

5. Méthode selon la revendication 4,
**caractérisée en ce**
**que** le nombre de valeurs d'échantillonnage x (k) déterminé a pour valeur zéro (Figure 2).

6. Méthode selon l'une quelconque des revendications précédentes,
**caractérisée en ce**
**que** l'étape e) est exécutée pour toutes les plages de valeurs d'origine (A1, A3), en particulier au cours de la séquence où les plages de valeurs d'origine (A1, A3) sont disposées dans la plage totale de valeurs.

7. Méthode selon l'une quelconque des revendications précédentes,
**caractérisée en ce**
**que**, à l'étape d), les R valeurs d'échantillonnage de x (k-R) à x (k0-1) dans le premier intervalle d'échantillonnage est égal au nombre N de plages de valeurs d'origine ou égal à un entier multiple du nombre N des plages de valeurs d'origine.

8. Méthode selon l'une quelconque des revendications précédentes,
**caractérisée en ce**
**qu'**une subdivision obligatoire ou une combinaison obligatoire de plages de valeurs modifiées (A2, A5, A6) est exécutée selon une procédure de correction.

9. Appareil pour échantillonner un signal continu avec un intervalle d'échantillonnage constant de préférence, dans lequel une caractéristique de quantification d'origine (200) est modifiée de manière adaptative et section par section, et par limites de plages de valeurs pour des valeurs d'échantillonnage x (k), où k est un nombre naturel, associées avec des mots de code b (j), où j = 1, 2, ..., N, et N est un nombre naturel indiquant une position dans la séquence d'échantillonnage, et automatiquement définies, ayant les unités suivantes :
a) ayant une unité d'association d'origine, formée de telle sorte que, en fonction de la caractéristique de quantification d'origine (200), les valeurs d'échantillonnage x (k) respectives sont associées à N mots de code b (j) lorsque la quantification et les limites de plages de valeurs s'égalisent, dans lequel des sauts N-1 ont lieu entre les niveaux de quantification N, dans lequel
b) une plage totale de valeurs pour les valeurs d'échantillonnage x (k) est subdivisée en N plages de valeurs d'origine (A1, A3), et
c) où, à chaque fois, un mot de code b (j) est associé aux N plages de valeurs d'origine (A1, A3),
d) ayant une unité de détermination, formée de telle sorte que, pour R valeurs d'échantillonnage de x (k0-R) à x (k0-1), aux instants d'échantillonnage de k0-R à k0-1 dans un premier intervalle d'échantillonnage, le nombre de valeurs d'échantillonnage x (k) dans une plage de valeurs d'origine (A1, A3) est déterminé, où R est un nombre naturel,
e) ayant une unité de définition, formée de telle sorte que, en fonction du nombre de valeurs d'échantillonnage x (k) déterminé, une adaptation de la résolution de quantification de la distribution statistique des valeurs d'échantillonnage est réalisée dans les plages de valeurs ou dans les mots de code, en insérant au moins un saut (170) dans une plage de valeurs d'origine (A1, A3) ou en supprimant un saut dans au moins une limite de plage de valeurs d'origine, et
f) dans lequel la plage de valeurs modifiées (A2, A5) est associée à un mot de code, ce qui a pour conséquence de générer une caractéristique de quantification modifiée (210) pour le deuxième intervalle d'échantillonnage suivant avec V+1 valeurs d'échantillonnage x (k0) à x (k0+V) aux instants d'échantillonnage k0 à k0+V, où V est un nombre naturel et k0+V désigne une position (30).

10. Appareil selon la revendication 9,
**caractérisé en ce**
**que** l'appareil contient un processeur qui, au moment de l'exécution d'un programme, exécute le traitement de l'unité d'association d'origine, de l'unité de détermination et de l'unité de définition, ou
**que** l'appareil intègre un circuit qui n'inclut aucun processeur et qui exécute le traitement d'au moins une des unités mentionnées ou de toutes ces unités.
